# EUROPÄISCHE PATENTSCHRIFT

(11) **EP 1 220 816 B1**
(45) Veröffentlichungstag und Bekanntmachung des Hinweises auf die Patenterteilung: **17.12.2003**
(21) Anmeldenummer: 00966081.2
(22) Anmeldetag: 28.09.2000
(51) Int. Cl.: C01B 33/027

(54) **VERFAHREN ZUR HERSTELLUNG VON HOCHREINEM, GRANULAREM SILIZIUM BEI NIEDRIGEM DRUCK**
METHOD FOR PRODUCING HIGHLY PURE, GRANULAR SILICONE AT LOW PRESSURE
PROCEDE DE PRODUCTION DE SILICIUM DE GRANDE PURETE EN GRANULES A UNE FAIBLE PRESSION

(30) Priorität: 11.10.1999 DE 19948932
(43) Veröffentlichungstag der Anmeldung: 10.07.2002
(73) Patentinhaber: SolarWorld Aktiengesellschaft, 53113 Bonn (DE)
(72) Erfinder: MLECZKO, Leslaw, 44801 Bochum (DE); HEROLD, Heiko, 41470 Neuss (DE); BUCHHOLZ, Sigurd, 50825 Köln (DE)
(74) Vertreter: Rau, Albrecht
(86) Internationale Anmeldenummer: EP0009479
(87) Internationale Veröffentlichungsnummer: WO01027029

(56) Entgegenhaltungen:
- GB-A- 1 570 131
- US-A- 3 012 861
- US-A- 4 154 870

## Beschreibung

Die vorliegende Erfindung betrifft ein Verfahren zur Herstellung von hochreinem, granularem Silizium durch Zersetzung eines siliziumhaltigen Gases, insbesondere von Silanen bei reduziertem Druck. Weiterhin betrifft die Erfindung die Verwendung des so hergestellten elementaren Siliziums in der Photovoltaik und der Halbleitertechnologie.

Unter siliziumhaltigen Gasen werden Siliziumverbindungen oder Gemische von Siliziumverbindungen verstanden, die unter den erfindungsgemäßen Bedingungen gasförmig sind. Siliziumfreie Gase im Sinne dieser Erfindung sind solche Gase, die keine Siliziumverbindungen enthalten.

Zur Gewinnung von elementarem Silizium eines Reinheitsgrades, das dessen Verwendung in der Photovoltaik beziehungsweise in der Halbleitertechnologie erlaubt, sind Verfahren zur thermischen Zersetzung von flüchtigen Siliziumverbindungen bekannt. Solche thermischen Zersetzungen werden beispielsweise in Siemens-Reaktoren durchgeführt. In diesem Reaktortyp erfolgt die thermische Zersetzung an der Oberfläche eines Stabes. Geeignet sind auch Wirbelschichtreaktoren, in denen kleine Siliziumpartikel vorgelegt und diese durch Einströmen eines geeigneten siliziumhaltigen Gases oder Gasgemisches fluidisiert werden. Die thermische Zersetzung der flüchtigen Siliziumverbindung soll im Idealfall ausschließlich auf der Oberfläche der vorgelegten Siliziumpartikel stattfinden.

US-3.012.861 offenbart ein Verfahren zur Herstellung elementaren Siliziums in einem Wirbelschichtreaktor. Als Siliziumverbindungen werden Silane und Halosilane verwendet, die mit weiteren Gasen verdünnt sein können. Geeignete Gase zur Verdünnung sind etwa Argon oder Helium, im Falle von Silan kann auch Wasserstoff eingesetzt werden. Die Reaktion kann in einem großen Druckbereich durchgeführt werden. Wird als Siliziumverbindung unverdünntes SiH₄ oder SiI₄ verwendet, ist laut US-3.012.861 eine Reaktionsführung bei niedrigem Druck vorteilhaft. Für unverdünntes SiH₄ wird ein bevorzugter Druck von etwa 5 mmHg (etwa 6,7 mbar) und darunter genannt. Für unverdünntes SiI₄ liegt der bevorzugte Druckbereich unterhalb von 0,1 µbar. In Beispiel 3 wird als Siliziumverbindung unverdünntes SiH₄ bei einem Reaktionsdruck von 1 mmHg (etwa 1,3 mbar) eingesetzt. Die Ausbeute an erhaltenem Silizium bezogen auf eingesetztes SiH₄ beträgt nur 14 %. Wird, wie in Beispiel 4, hingegen bei nahezu Atmosphärendruck gearbeitet, so kommt es zur vermehrten Bildung von Siliziumstaub. Der Siliziumstaub hat eine sehr große spezifische Oberfläche und wird deshalb so leicht kontaminiert, dass er keine weitere Verwendung auf dem Gebiet der Photovoltaik oder der Halbleitertechnologie findet. Demzufolge ist die Staubbildung unerwünscht. Das Zugeben von Wasserstoff in einem 25-fachen molaren Überschuss, wie in Beispiel 7, führt bei Reaktionsführung bei nahezu Atmosphärendruck zu einer Siliziumausbeute bezogen auf eingesetztes SiH₄ von größer 95 % und einer Siliziumstaubbildung kleiner 1 %.

Auch in US-4.684.513 wird die Bildung von Siliziumstaub als Problem bei der Silanpyrolyse beschrieben. Um die Staubbildung zu vermindern, wird die Silanpyrolyse in einem speziellen Reaktor durchgeführt, durch dessen Aufbau sich ein ganz bestimmtes Temperaturprofil realisieren lässt. Das siliziumhaltige Gas; das der Pyrolyse zugeführt wird, wird bevorzugt mit 50 Vol.-% eines weiteren Gases oder Gasgemischs verdünnt.

Die Zugabe eines Gases zur Verdünnung hat jedoch mehrere Nachteile. Das zusätzliche Einbringen einer Komponente in den Reaktionsraum birgt das Risiko, Verunreinigungen einzutragen, die die Reinheit des hergestellten Siliziums verringern. Der verwendete Reaktor muss für eine vorgegebene Produktionsmenge größer sein und der Energieverbrauch steigt, da nicht nur das Reaktionsgas, d.h. die gasförmige Siliziumverbindung, sondern auch das als Verdünnungsgas eingesetzte siliziumfreie Gas auf die für die thermische Zersetzung der Siliziumverbindung benötigte Temperatur gebracht werden muss. Zudem muss aus wirtschaftlichen Gesichtspunken das verwendete Gas rezykliert werden, was zusätzliche apparative Maßnahmen erfordert.

US-5.798.137 beschreibt ein Verfahren für die Abscheidung von Silizium aus einem siliziumhaltigen Gas in einem speziellen Wirbelschichtreaktor, der aus mehreren Zonen besteht, wobei das siliziumhaltige Gas nicht über Einbauten zur Gasverteilung sondern direkt über eine Düse zugeführt wird. Nach diesem Verfahren ist es möglich, siliziumhaltige Gase ohne Zugabe eines Verdünnungsgases thermisch so zu zersetzen, dass die Bildung von Siliziumstaub verringert wird. Ein vollständiges Zurückdrängen der Staubbildung gelingt jedoch nicht. Die Durchführung des Verfahrens ist zudem mit einem hohen apparativen Aufwand verbunden.

Neben den bereits erwähnten Problemen, treten bei der thermischen Zersetzung siliziumhaltiger Gase weitere Probleme auf. Ein Überblick über solche Probleme ist beispielsweise in US-5.798.137 gegeben.

Die thermische Siliziumabscheidung aus siliziumhaltigen Gasen erfolgt in der Regel oberhalb der Tammann-Temperatur von Silizium (ca. 52% der Schmelztemperatur von Silizium). Ab dieser Temperatur verhalten sich Materialien "klebrig" und es kann zur Agglomeratrion der Bettpartikeln kommen. Dies führt zur Defluidisierung und zum Verstopfen des Reaktors oder des Gasverteilers. So kommt es oberhalb einer kritischen Silankonzentration (>15 bis 20 Vol-% Silan bezogen auf das insgesamt zugeführte Gas) regelmäßig zur Agglomeration und Defluidisierung des Bettes in Wirbelschichtreaktoren. Silankonzentrationen unterhalb dieses kritischen Werts haben andererseits den Nachteil, dass nur mäßige Raum-Zeit-Ausbeuten erreicht werden.

Problematisch ist weiterhin ein hoher Energiebedarf und Abscheidungen von Silizium an den Reaktorwänden. Liegt die Wandtemperatur des zur Zersetzung verwendeten Reaktors hoch, so kommt es zur vermehrten Abscheidungen von Silizium auf den Wänden des Reaktors (vergleiche US-4.818.495 und US-4.684.513). Dies kann unter anderem zu einem verschlechterten Wärmeübergang, zur Beschädigung des Reaktors durch unterschiedliche Wärmeausdehnungskoeffizienten von Reaktorwand und abgeschiedener Siliziumschicht (vergleiche US-3,963,838) und zur Verunreinigung der Partikel durch Diffusion von Metallen aus dem Reaktormantel in die durch die Wandabscheidung gebildete Siliziumschicht führen.

Ein Problem ist auch der Wasserstoffgehalt des durch Abscheidung gebildeten Siliziums. Bei der Abscheidung von Silizium aus wasserstoffhaltigen Verbindungen spielt der Restwasserstoffgehalt des Siliziums eine große Rolle. Ist der Wasserstoffgehalt hoch, so kommt es zu Schwierigkeiten beim Aufschmelzen des Siliziums. Diese Probleme sind als sogenanntes "Popcorning" bekannt: Beim Aufschmelzen platzen die Partikel auf und es bilden sich poröse Strukturen aus, die den Flussprozess stören. Dieses Problem beim Aufschmelzen ist allgemein bekannt und wird beispielsweise in US-5,810,934 beschrieben.

Aus der GB 1 570 131 A ist ein Verfahren zur Herstellung von hochreinem, granularem Silizium durch Zersetzung eines siliziumhaltigen Gases bei einem Druck zwischen 0,6 und 30 bar bekannt.

Der vorliegenden Erfindung lag die Aufgabe zugrunde, ein Verfahren bereitzustellen, nach dem für die Photovoltaik und die Halbleitertechnologie geeignetes, hochreines, granulares Silizium in hoher Ausbeute durch Zersetzung eines siliziumhaltigen Gases, insbesondere eines gasförmigen Silans, in einem Wanderbettreaktor oder einem Wirbelschichtreaktor gewonnen werden kann, wobei die oben genannten Probleme weitgehend zurückgedrängt werden sollten.

Die vorliegende Erfindung betrifft ein Verfahren zur Herstellung von hochreinem, granularem Silizium durch Zersetzung eines siliziumhaltigen Gases, dadurch gekennzeichnet, dass die Zersetzung bei einem Druck von 100 bis 900 mbar durchgeführt wird. Die Einströmgeschwindigkeit des zugeführten Gases beträgt bei dieser Ausführungsform die ein- bis zehnfache, bevorzugt die eineinhalb- bis siebenfache Lockerungsgeschwindigkeit.

Überraschenderweise können in dem erfindungsgemäß anzuwendenden Druckbereich sowohl die Nachteile des Arbeitens bei höheren Drucken (Staubbildung, Zusatz großer Mengen an Fremdgas und damit verbunden hoher Energiebedarf bzw. hohe Temperaturen der Reaktorwand) und die Nachteile des Arbeitens bei niedrigeren

Drucken (geringe Ausbeuten bezogen auf die Menge der eingesetzten Siliziumverbindung und geringe Raum-Zeit-Ausbeute) vermieden werden. Unerwarteterweise lassen sich auch in Wirbelschichtreaktoren Konzentrationen von siliziumhaltigem Gas bis zu 100 Vol-% an gesamt zugeführtem Gas realisieren, ohne dass es zur Defluidisierung der Wirbelschicht, d.h. zur Agglomeration der Bettpartikel kommt. Auch die Probleme des sogenannten "Popcorning" werden aufgrund des geringeren Wasserstoffpartialdrucks zurückgedrängt. Es wäre zu erwarten gewesen, dass in einem mittleren Druckbereich die Nachteile der Arbeitsweise bei höherem und zusätzlich die Nachteile der Arbeitsweise bei niedrigerem Druck auftreten.

Nach dem erfindungsgemäßen Verfahren lässt sich beispielsweise SiH₄ nahezu quantitativ umsetzen. Es werden Ausbeuten an gewünschtem hochreinem, granularem Silizium von >90 %, bezogen auf eingesetztes SiH₄, erreicht.

Das erfindungsgemäße Verfahren kann in verschiedenen Reaktortypen durchgeführt werden. Bevorzugt ist die Verwendung eines Wirbelschichtreaktors. Geeignete Reaktoren, insbesondere Wirbelschichtreaktoren sind bereits bekannt. Beispielhaft seien hier Reaktoren mit blasenbildender oder zirkulierender Wirbelschicht genannt, des Weiteren Sprudelbett- und Fallrohrreaktoren. Das Verfahren lässt sich beispielsweise kontinuierlich oder diskontinuierlich durchführen. Bevorzugt ist die kontinuierliche Vorgehensweise.

Der Austrag des gebildeten hochreinen, granularen Siliziums aus dem verwendeten Reaktor kann beispielsweise kontinuierlich oder absatzweise erfolgen.

Als siliziumhaltiges Gas kommen Silane, Siliziumiodide und Halosilane des Chlors, Broms und Iods in Frage. Es können auch Gemische der genannten Verbindungen verwendet werden. Dabei ist es unerheblich, ob die Siliziumverbindung bei Raumtemperatur bereits gasförmig ist oder zunächst in den Gaszustand überführt werden muss. Die Überführung in den Gaszustand kann beispielsweise thermisch erfolgen.

Bevorzugt werden Silane eingesetzt. Beispielhaft seien SiH₄, Si₂H₆, Si₃H₈, Si₄H₁₀ und Si₆H₁₄ genannt. Besonders bevorzugt ist SiH₄.

Das erfindungsgemäße Verfahren wird bei Drucken von 100 bis 900 mbar, bevorzugt bei Drucken von 200 bis 800 mbar durchgeführt. Besonders bevorzugt ist der Druckbereich 300 bis 700 mbar, insbesondere bevorzugt 400 bis 600 mbar. Alle angegebenen Druckwerte sind absolute Druckwerte. Wird das erfindungsgemäße Verfahren in einem Wirbelschichtreaktor durchgeführt, ist unter dem genannten Druck der Druck zu verstehen, der, in Strömungsrichtung des zugeführten Gasstroms gesehen, hinter der Wirbelschicht herrscht.

In einer besonderen Ausführungsform des erfindungsgemäßen Verfahrens zur Herstellung hochreinen, granularen Siliziums werden bis zu 50 Vol-% eines siliziumfreien Gases, bezogen auf das insgesamt zugeführte Gas, zugesetzt. Vorzugsweise beträgt die zugesetzte Menge an siliziumfreiem Gas 0 bis 40 Vol-%, besonders bevorzugt 0 bis 20 Vol-%. Der Zusatz des siliziumfreien Gases verringert die Bildung von Siliziumstaub, andererseits erfordert ein solcher Zusatz einen höheren Energieaufwand und führt zu einer verringerten Raum-Zeit-Ausbeute. Bevorzugt ist die Ausführungsform ohne Zusatz eines siliziumfreien Gases.

Geeignete siliziumfreie Gase sind beispielsweise die Edelgase, Stickstoff und, für den Fall, dass als siliziumhaltges Gas Silan eingesetzt wird, Wasserstoff, wobei die siliziumfreien Gase einzeln oder in beliebiger Kombination eingesetzt werden können. Bevorzugt sind Stickstoff und Wasserstoff, besonders bevorzugt ist Wasserstoff.

Die Temperatur kann im Temperaturbereich von 300°C bis 1 400°C variiert werden. Sie muss jedoch so hoch sein, dass die Zersetzung des siliziumhaltigen Gases gewährleistet ist und darf die Schmelztemperatur des hergestellten Siliziums nicht überschreiten. Bei Verwendung von SiH₄ liegt der vorteilhafte Temperaturbereich zwischen 500°C und 1400°C. Bevorzugt ist eine Zersetzungstemperatur von 600°C bis 1000°C, besonders bevorzugt 620°C bis 700°C. Bei Verwendung von Sil₄ liegt der entsprechende Bereich zwischen 850° C und 1250° C, bei Halosilanen zwischen 500° C und 1400° C.

In einer bevorzugten Ausführungsform des erfindungsgemäßen Verfahrens werden in Wirbelschichtreaktoren im Reaktionsraum Feststoffpartikel, im Weiteren Partikel genannt, vorgelegt. Die Partikel können absatzweise oder auch kontinuierlich von außen zugeführt werden. Als Partikel können jedoch auch solche Partikel Verwendung finden, die im Reaktionsraum generiert werden. Die Partikel bilden ein Festbett, durch das das zugeführte Gas eingeströmt wird. Die Einströmgeschwindigkeit des zugeführten Gases wird so eingestellt, dass das Festbett fluidisiert wird und sich eine Wirbelschicht ausbildet. Die entsprechende Vorgehensweise ist dem Fachmann an und für sich bekannt. Die Einströmgeschwindigkeit des zugefuhrten Gases muss mindestens der Lockerungsgeschwindigkeit entsprechen. Unter Lockerungsgeschwindigkeit wird dabei die Geschwindigkeit verstanden, mit der ein Gas durch ein Bett aus Partikeln strömt und unterhalb derer das Festbett erhalten bleibt, d. h. unterhalb derer die Bettpartikel weitgehend unbewegt bleiben. Oberhalb dieser Geschwindigkeit beginnt die Fluidisierung des Betts, d. h. die Bettpartikel bewegen sich und es bilden sich erste Blasen.

Vorteilhaft werden Partikel eingesetzt, die einen Durchmesser von 50 bis 5000 µm aufweisen.

Bei den verwendeten Partikeln handelt es sich vorzugsweise um Siliziumpartikel. Vorteilhafter Weise haben diese Siliziumpartikel die Reinheit, die auch für das hergestellte hochreine, granulare Silizium gewünscht wird. Es ist aber auch möglich Siliziumpartikel mit bestimmten Dotierungen einzusetzen, wenn dotiertes Material gewünscht wird. Es eignen sich auch Partikel, die nicht aus Silizium bestehen, solange sie unter den Reaktionsbedingungen stabil sind.

Wird dotiertes Material gewünscht, kann beispielsweise auch so vorgegangen werden, dass während des Herstellungsprozesses geeignete Stoffe zugesetzt werden. Geeignete Stoffe sind beispielsweise Verbindungen des Phosphors oder des Bors oder Aluminiums.

Das nach dem erfindungsgemäßen Verfahren hergestellte Silizium kann in verschiedenen Bereichen eingesetzt werden. Beispielsweise auf dem Gebiet der Photovoltaik, z.B. als Ausgangsmaterial zur Herstellung von Solarzellen oder in der Halbleitertechnologie, z.B. bei der Herstellung von elektronischen Bauteilen.

Durch die folgenden Beispiele wird das erfindungsgemäße Verfahren weiter illustriert, wobei die Erfindung nicht auf diese Beispiele beschränkt ist.

### Beispiele

### Beispiel 1: Berechnungsbeispiel

Es wurde anhand eines Berechnungsmodells der spezifische Energiebedarf und die Wandtemperatur eines technischen Wirbelschichtreaktors für die thermische Zersetzung von Siliziumverbindungen am Beispiel Silan ermittelt.

Bei den Berechnungen wurde aufgrund des Standes der Technik von den folgenden Annahmen ausgegangen: Reaktordurchmesser: 1,5 m; Reaktorhöhe: 4 m; Partikeldurchmesser: 800 µm; Gasgeschwindigkeit am Reaktoreingang: 1,35 m·s⁻¹. Es wurde den Berechnungen ein Partialdruck von Silan von p(SiH₄) = 200 mbar zugrundegelegt. Der Wäremeübergangskoeffizient wurde nach einer Korrelation des VDI-Wärmeatlas berechnet.

**Tabelle**

| **Vergleich der Normal- und Unterdruckfahrweise bei der thermischen Zersetzung von Silan** | | |
|---|---|---|
| Druck, bar | 1 | 0,2 |
| p(SiH₄), bar | 0,2 | 0,2 |
| Silanstrom, kg·h⁻¹ | 720 | 720 |
| H₂-Strom, kg·⁻¹ | 192 | - |
| Wärmeübergangskoeffizient α, | 1140 | 722 |
| W·m²·K⁻¹ | | |
| Leistungsbedarf, kW | 558 | 98 |
| Spez. Leistugsbedarf, kJ·kg(Si)⁻¹ | 3000 | 560 |
| Wandtemperatur | 676 | 657 |

Aus der Tabelle wird deutlich, dass der spezifische Leistungsbedarf bei der Unterdruckfahrweise bei gleicher Produktionsrate nur etwa ein Fünftel des Leistungsbedarfes einer Fahrweise bei Normaldruck mit Wasserstoff als Fluidisierungsgas beträgt. Die Wandtemperatur des Reaktors liegt darüber hinaus 20°C unterhalb der Wandtemperatur bei Normaldruckbetrieb. Im Unterdruckbetrieb sind daher weniger Abscheidungen auf der Wand des Reaktors zu erwarten. Diese beiden Werte illustrieren die Vorteile der Unterdruckfahrweise.

### Beispiel 2:

### a) SiH₄-Zersetzung bei Normaldruck (Vergleich)

In einem Versuchswirbelschichtreaktor (Durchmesser = 52,4 mm, Höhe mit expandiertem Kopf = 1600 mm) wurden 600 g Siliziumpartikeln mit einem Durchmesser von 250-355 µm vorgelegt. Das Experiment wurde bei leichtem Überdruck (ca. 150 mbar) im Reaktor durchgeführt, um den Druckverlust über Gasverteiler, fluidisierte Partikeln und Ventile auszugleichen. Nach dem Anfahren und Aufheizen des Wirbelbettes auf eine Temperatur von 650°C wurde eine Silankonzentration (SiH₄) am Eingang des Reaktors von 10 Vol-% bezogen auf das Fluidisierungsgas Wasserstoff eingestellt. Direkt nach dem Einstellen der Silankonzentration agglomerierten die Siliziumpartikeln im Bett und es kam zu einer irreversiblen Defluidisierung (Verkleben des Materials). Stabile Betriebszustände wurden bei Normaldruck reproduzierbar für längere Zeit nur bei Silankonzentrationen <10 Vol-% bezogen auf das Fluidisierungsgas Wasserstoff erhalten.

### b) SiH₄-Zersetzung bei Unterdruck und geringer Silankonzentration (Vergleich)

. Es wurde nun bei Unterdruck (p = 800 mbar abs.) im oben beschriebenen Reaktor gearbeitet. Der Unterdruck wurde durch eine Vakuumpumpe gehalten. Es wurden erneut 600 g Siliziumpartikeln mit einem Durchmesser von 250-355 µm vorgelegt. Nach dem Einstellen der Silankonzentration auf 10 Vol-% bezogen auf das Fluidisierungsgas Wasserstoff wurde die thermische Zersetzung der Partikeln problemlos für mehr als 30 Minuten durchgeführt. Der Silanumsatz lag bei nahezu 100 % und es wurden insgesamt 81,08 g Si abgeschieden. Eine Analyse der Reaktionsprodukte zeigte nach der Reaktionsdurchführung, dass das zersetzte Silan zu 98,7 % auf den Bettpartikeln abgeschieden war und zu 1,3 % als Feinstaub in einem nachgeschalteten Zyklon und Filter gesammelt wurde. Versuch 2b zeigt, dass ein Arbeiten bei Unterdruck die Defluidisierung verhindert.

### Beipiel 3:

In dem in Beispiel 2 beschriebenen Versuchsreaktor wurde ein Unterdruckexperiment (500 mbar abs.) durchgeführt, bei dem die Konzentration von Silan bei 100 Vol.-% gehalten wurde. Die Experimente wurden in dem in Beispiel 2 beschriebenen Reaktor durchgeführt. Nach dem Aufheizen des Bettes (800 g Si, Partikeldurchmesser: 250-355 µm,) auf eine Temperatur von 650-670°C wurde die Silankonzentration auf 100 Vol.-% eingestellt. Die Wirbelschicht wurde stabil über einen Zeitraum von mehr als 40 Minuten betrieben. Dabei wurden 293,0 g Silizium auf den Bettpartikeln abgeschieden und 39,9 g wurden als Feinstaub in den dem Reaktor nachgeschalteten Zyklon und Filter gesammelt.

Dieses Beispiel zeigt, dass bei einem Druck im Reaktor von 500 mbar abs. die Silankonzentration auf bis zu 100 % erhöht werden kann und sich dennoch eine stabile Fluidisierung des Bettes und lange Laufzeiten der Experimente ergeben, während und nach der keine Defluidisierung und Agglomeration beobachtet wird.

Das nach Beispiel 2b und 3 produzierte Silizium wurde oberflächenanalytisch (XPS) und volumenanalytisch (ICP) analysiert. Der Gehalt an Verunreinigungen lag unterhalb der Nachweisgrenze der beiden Methoden.

## Patentansprüche

1. Verfahren zur Herstellung von hochreinem, granularem Silizium durch Zersetzung eines siliziumhaltigen Gases bei einem Druck von 100 bis 900 mbar, **dadurch gekennzeichnet, dass** die Gasstromgeschwindigkeit des zugeführten Gases im Verhältnis zur Lockerungsgeschwindigkeit Werte von 1 bis 10 annimmt.

2. Verfahren nach Anspruch 1, **dadurch gekennzeichnet, dass** der Druck 200 bis 800 mbar beträgt.

3. Verfahren nach wenigstens einem der Ansprüche 1 bis 2, **dadurch gekennzeichnet, dass** zusätzlich zum siliziumhaltigen Gas bis zu 50 Vol.-% eines siliziumfreien Gases, bezogen auf die Gesamtmenge des zugeführten Gases, zugegeben werden.

4. Verfahren nach wenigstens einem der Ansprüche 1 bis 3, **dadurch gekennzeichnet, dass** als siliziumfreies Gas Wasserstoff und/oder Stickstoff verwendet wird.

5. Verfahren nach wenigstens einem der Ansprüche 1 bis 4, **dadurch gekennzeichnet, dass** die Zersetzung in Gegenwart von Partikeln durchgeführt wird, die vom zugeführten Gas derart durchströmt werden, dass die Partikel fluidisiert werden und sich eine Wirbelschicht ausbildet.

6. Verfahren nach wenigstens einem der Ansprüche 1 bis 5, **dadurch gekennzeichnet, dass** als Partikel Siliziumpartikel verwendet werden.

7. Verfahren nach wenigstens einem der Ansprüche 1 bis 6, **dadurch ge** **kennzeichnet, dass** die Partikel einen Durchmesser zwischen 50 und 5000 µm aufweisen.

8. Verfahren nach wenigstens einem der Ansprüche 1 bis 7, **dadurch gekennzeichnet, dass** die Zugabe von Partikeln und der Austrag des hergestellten Siliziums kontinuierlich oder absatzweise durchgeführt wird.

9. Verfahren nach wenigstens einem der Ansprüche 1 bis 8, **dadurch gekennzeichnet, dass** als siliziumhaltiges Gas ein Silan, bevorzugt SiH₄ verwendet wird.

10. Verfahren nach wenigstens einem der Ansprüche 1 bis 9, **dadurch gekennzeichnet, dass** als siliziumhaltiges Gas SiH₄ verwendet und bei Temperaturen von 500 bis 1400° C gearbeitet wird.

11. Verfahren nach wenigstens einem der Ansprüche 1 bis 10, **dadurch gekennzeichnet, dass** während des Herstellungsprozesses geeignete Stoffe zugesetzt werden, die zu einer Dotierung des entstehenden Siliciums führen.

12. Verfahren nach einem der Ansprüche 1 bis 11, **dadurch gekennzeichnet, dass** das Produkt Silizium zu photovoltaischen Bauteilen weiterverarbeitet wird.

13. Verfahren nach einem der Ansprüche 1 bis 11, **dadurch gekennzeichnet, dass** das Produkt Silizium zu elektronischen Bauteilen weiterverarbeitet wird.

## Claims

1. A method for manufacturing high-purity granular silicon by decomposing a gas containing silicon at a pressure of 100 to 900 mbar, **characterized in that** the ratio between the gas stream velocity of the supplied gas and the loosening velocity ranges from 1 to 10.

2. A method according to claim 1, **characterized in that** the pressure amounts to 200 to 800 mbar.

3. A method according to at least one of claims 1 to 2, **characterized in that** up to 50 volume percent of a silicon-free gas relative to the total amount of the supplied gas is added to the gas containing silicon.

4. A method according to at least one of claims 1 to 3, **characterized in that** at least one of hydrogen and nitrogen is used as silicon-free gas.

5. A method according to at least one of claims 1 to 4, **characterized in that** the decomposition takes place in the presence of particles through which the supplied gas streams so that said particles become fluidised and a fluidised bed is formed.

6. A method according to at least one of claims 1 to 5, **characterized in that** silicon particles are used as particles.

7. A method according to at least one of claims 1 to 6, **characterized in that** the diameter of the particles ranges from 50 to 5,000 µm.

8. A method according to at least one of claims 1 to 7, **characterized in that** the addition of particles and the discharge of the manufactured silicon is performed continuously or intermittently.

9. A method according to at least one of claims 1 to 8, **characterized in that** a silane, preferably SiH₄, is used as gas containing silicon.

10. A method according to at least one of claims 1 to 9, **characterized in that** SiH₄ is used as gas containing silicon and the operating temperature ranges from 500 to 1,400 °C.

11. A method according to at least one of claims 1 to 10, **characterized in that** suitable substances are added during the manufacturing process resulting in the formed silicon being doped.

12. A method according to one of claims 1 to 11, **characterized in that** the silicon is processed in photovoltaic components.

13. A method according to one of claims 1 to 11, **characterized in that** the silicon is processed in electronic components.

## Revendications

1. Procédé de préparation de silicium granulaire à haute pureté par décomposition d'un gaz contenant du silicium, sous une pression de 100 à 900 mbar, **caractérisé en ce que** la vitesse d'écoulement du gaz introduit vis-à-vis de la vitesse de fluidisation (mise en suspension) prend une valeur de 1à 10.

2. Procédé selon la revendication 1, **caractérisé en ce que** la pression est de 200 à 800 mbar.

3. Procédé selon l'une au moins des revendications 1 à 2, **caractérisé en ce que**, outre le gaz contenant du silicium, on ajoute jusqu'à 50% en volume d'un gaz exempt de silicium, par rapport à la quantité totale du gaz d'alimentation.

4. Procédé selon l'une au moins des revendications 1 à 3, **caractérisé en ce que** l'on utilise comme gaz exempt de silicium de l'hydrogène et.ou de l'azote.

5. Procédé selon l'une au moins des revendications 1 à 4, **caractérisé en ce que** la décomposition est entreprise en présence de particules qui sont balayées par le gaz d'alimentation, de telle manière que les particules soient fluidisées et qu'il se forme une couche fluidisée.

6. Procédé selon l'une au moins des revendications 1 à 5, **caractérisé en ce que** l'on utilise comme particules des particules de silicium.

7. Procédé selon l'une au moins des revendications 1 à 6, **caractérisé en ce que** les particules ont un diamètre entre 50 et 5000 µm.

8. Procédé selon l'une des revendications 1 à 7, **caractérisé en ce que** l'amenée de particules et la décharge du silicium préparé sont entreprises en continu ou par lots.

9. Procédé selon l'une au moins des revendications 1 à 8, **caractérisé en ce que** l'on utilise comme gaz contenant du silicium un silane, de préférence du SiH₄.

10. Procédé selon l'une au moins des revendications 1 à 9, **caractérisé en ce que** l'on utilise comme gaz contenant du silicium du SiH₄, et que l'on travaille à des températures de 500 à 1400°C.

11. Procédé selon l'une au moins des revendications 1 à 10, **caractérisé en ce que**, pendant le procédé de préparation, on ajoute des substances appropriées qui conditionnent un dopage du silicium formé.

12. Procédé selon l'une au moins des revendications 1 à 11, **caractérisé en ce que** le produit de silicium est retraité pour la production d'éléments photovoltaïques.

13. Procédé selon l'une au moins des revendications 1 à 11, **caractérisé en ce que** le produit de silicium est retraité pour la production de composants électroniques.
